# EUROPÄISCHE PATENTSCHRIFT

(11) **EP 2 686 879 B1**
(45) Veröffentlichungstag und Bekanntmachung des Hinweises auf die Patenterteilung: **20.01.2016**
(21) Anmeldenummer: 12711593.9
(22) Anmeldetag: 09.03.2012
(51) Int. Cl.: H01L 23/433

(54) **WÄRMELEITFOLIE FÜR DIE ENTWÄRMUNG UND FIXIERUNG ELEKTRONISCHER BAUELEMENTE**
THERMALLY CONDUCTIVE FILM FOR COOLING AND FASTENING ELECTRONIC COMPONENTS
FEUILLE THERMOCONDUCTRICE POUR DISSIPER LA CHALEUR ET FIXER DES COMPOSANTS ÉLECTRONIQUES

(30) Priorität: 17.03.2011 DE 102011005669
(43) Veröffentlichungstag der Anmeldung: 22.01.2014
(73) Patentinhaber: Robert Bosch GmbH, 70442 Stuttgart (DE)
(72) Erfinder: BARTSCHERER, Peter, 71638 Ludwigsburg (DE); MONORY-PLANTIER, Carole, 71665 Vaihingen (DE); HAHN, Robert, 72770 Reutlingen (DE)
(86) Internationale Anmeldenummer: PCT/EP2012/054134
(87) Internationale Veröffentlichungsnummer: WO 2012/123367

(56) Entgegenhaltungen:
- EP-A2- 0 875 933
- JP-A- 61 290 743
- JP-A- 2004 172 286
- US-A1- 2004 118 501
- US-A1- 2006 270 106

## Beschreibung

### Stand der Technik

Die Erfindung betrifft Wärmeleitfolien zur Entwärmung elektrischer und/oder elektronischer Bauelemente, und insbesondere solche Folien die auch eine fixierende Wirkung haben, wie z.B. eine Klebewirkung.

Zur Entwärmung von elektrischen/elektronischen Bauelementen bzw. Bauteilen in Geräten wie bspw. Elektroantrieben oder Steuergeräten im Automobilbereich (Fahrzeugbau) wird die Wärme unmittelbar, über zugeordnete Kühlkörper, und/oder Gehäuseteile abgeführt. Entsprechende Systeme zur thermischen Anbindung umfassen auch Lösungen zur effizienten thermischen Kopplung zwischen diesen Komponenten wie bspw. Wärmeleitpasten und Wärmeleitfolien. Derartige Systeme müssen immer höheren Anforderungen gerecht werden. So bedeuten höhere Leistungen, wie sie etwa für die in Zukunft zu entwickelnden reinen Elektrofahrzeuge gefordert werden, höhere elektrische Spannungen und Ströme. Damit verbunden sind größere Verlustleistungen, also Wärmemengen, die von dem zu entwärmenden Bauelement wegdiffundiert werden müssen.

Die Anordnung der Komponenten zueinander / im Gerät während der Montage und/oder über die Lebensdauer des Geräts wird über mechanische Fixierungen sichergestellt. Unter anderem kommen hierbei auch Klebefolien zum Einsatz. Es ist auch der Ansatz bereits bekannt, Wärmeleitfolien mit einer fixierenden (klebenden) Wirkung vorzusehen. Bspw kann eine klebende Wärmeleitfolie verwendet werden, um eine thermisch leitende Fixierung einer Leiterplatte oder einer LTCC ("Low Temperature Cofired Ceramics") sicherzustellen.

Neben möglichst guter thermischer Performance sollen klebende Wärmeleitfolien auch in ihrer Fixierungswirkung optimiert sein. Gleichzeitig soll die Entwärmung als auch die Fixierung einfach und kostengünstig dargestellt werden können.

Momentan sind Wärmeleitfolien bekannt, die eine gute thermische Performance bieten, beispielsweise durch die Verwendung von PCM ("Phase Change Materials"), Thermopads, etc. Auch Klebefolien mit guten Fixiereigenschaften sind als solche bekannt. Bei den bekannten klebenden Wärmeleitfolien sind allerdings bisher Kompromisse unvermeidlich; insbesondere stellt sich heraus, dass eine thermische Performance schlechter ist als bei reinen Wärmeleitfolien.

Ein Beispiel für eine hochentwickelte Wärmeleitfolie ist beispielsweise aus der DE 10 2004 039 565 A1 bekannt. Hier wird eine mehrlagige Wärmeleitfolie mit einer ersten Lage beschrieben, die aus einer elektrisch isolierenden, wärmeleitend verfüllten, hochelastischen Elastomerschicht gebildet ist. Diese Lage ist infolge ihrer Gel-Charakteristik dauerhaft an die unebene Oberflächenstruktur einer elektronischen Schaltung anformbar. Die Wärmeleitfolie umfasst als zweite Lage eine PCM-Schicht, die eine effiziente thermische Kopplung an einen Kühlkörper oder ein Gehäuseteil ermöglicht.

Aus der DE 43 36 961 A1/C2 sind ebenfalls mehrlagige Verbundkörper zur Wärmeableitung bekannt. Ein zweilagiger Verbundkörper umfasst beispielsweise eine Kunststoffschicht und eine Metallfolie. Der Körper kann gegebenenfalls um eine oder zwei außenliegende Klebeschichten ergänzt werden. Durch die Verwendung der Metallfolie soll der Wärmeübergang innerhalb des Verbundkörpers verbessert werden, so dass die Einleitung von elektronischen Bauteilen abzuführender Wärme in die Folie hinein erleichtert wird. Die Metallfolie kann von zwei Kunststoffschichten umfasst sein, wobei die Kunststoffschichten in einem Randbereich über die Metallfolie hinausreichen und dort parallel zusammengeführt und miteinander verschweißt sein können. Es kann ein Kunststoffisolationsmaterial auf Randbereiche des Mehrfach-Verbundschichtkörpers aufgespritzt oder aufgesprüht werden, um einen Randabschluss des Verbundkörpers zu erreichen.

Aus der US 6, 644,395 B1 ist ferner ein "Thermal Interface Pad" bekannt, bei denen eine PCM-Schicht zwischen Klebeschichten vorgesehen ist. Das Pad dient zur thermischen und mechanischen Kontaktierung von zu entwärmenden Bauteilen einerseits und Kühlkörpern andererseits. Eine klebende Abzugsschicht ist auf der PCM-Schicht vorgesehen, um diese während Lagerung, Transport und Montage vor Beschädigungen zu schützen. Vor der Befestigung an einem zu entwärmenden Bauelement wird die klebende Schutzschicht abgezogen, ohne Klebestoffreste oder Spuren auf der PCM-Schicht zu hinterlassen. Danach wird der Kühlkörper mit der aufgeklebten PCM-Schicht an dem zu entwärmenden Bauelement mittels Klammern, Schrauben oder dergleichen befestigt, ohne dass Klebstoffreste die thermische Performance verringern. Eine gewünschte Klebewirkung des Liners an der PCM-Schicht kann durch zonale Auftragung oder Strukturierung der Liner-Schicht erzielt werden.

Die oben beschriebenen Wärmeleitfolien können eine gute thermische Performance aufweisen, was die Wärmeweiterleitung im Inneren der Folie betrifft. Das Vorhandensein von Klebeschichten bedeutet allerdings immer einen Kompromiss bei der Wärmeleitung in die Folie hinein bzw. aus der Folie heraus.

Aus der US 2006/0270106 A1 ist eine Kopplung zwischen einem elektronischen Bauteil und einem Deckel bekannt, die aus metallischen Bereichen und einem kapselndem Polymer besteht. Die metallischen Bereiche sind oberhalb eines oder mehreres wärmeerzeugende Bauteile eines integrierten Schaltungschips angeordnet. Die Kapselung aus dem Polymerumschließt und fixiert dabei einen oder mehrere der metallischen Bereiche.

Durch die thermische Leitfähigkeit der metallischen Bereiche kann Wärme abgeführt werden, während durch die Kapselung eine Fixierung der metallischen Bereiche bewirkt wird und thermisch verursachte Bewegungen und mechanische Spannungen verhindert bzw. verringert werden.

Die EP 875933 A1 beschreibt eine thermische Schnittstelle, die dazu beiträgt, Wärme von einer wärmeerzeugenden Komponente, beispielsweise einer integrierten Schaltung, an eine wärmeabführende Komponente, beispielsweise eine Wärmesenke zu übertragen. Es ist eine zusammengesetzte thermische Schnittstelle gezeigt, die aus einer Schablone besteht, die aus einem Material wie beispielsweise einem Lückenanschlußflächenmaterial oder einem thermischen Band besteht und Hohlräume aufweist, die mit einem biegsamen Material gefüllt sind.

Aus der US2004/0118501 A1 ist ein System bekannt, dass mehrere ausgerichtete Wärmeübertragungsstrukturen in einem thermischen Grenzflächenmaterial (TIM) umfasst, um Wärme von einem Chip zu einer Wärmesenke zu übertragen. Das System umfasst ein Wärmeübertragungssubsystem, das auf der rückseitigen Oberfläche des Chips angeordnet ist.

In einer Ausführungsform umfasst die Wärmeübertragungsuntersystem eine Vielzahl von ausgerichteten ersten Wärmeübertragungsstrukturen, die anisotrop und diskret in einem zweiten Wärmeübertragungsmaterial angeordnet sind.

In der JP 2004172286 A ist eine wärmeleitfähige Folie beschrieben, die ein Wärmeleitelement umfasst, das aus einem porösen Material hergestellt ist.

### Offenbarung der Erfindung

Erfindungsgemäß wird eine Wärmeleitfolie zur Entwärmung und Fixierung mindestens eines elektrischen und/oder elektronischen Bauelementes vorgeschlagen, wobei die Wärmeleitfolie mindestens einen diskreten Entwärmungsbereich und mindestens einen diskreten Fixierungsbereich umfasst.

Der Entwärmungsbereich und der Fixierungsbereich erstrecken sich jeweils flächig in einer Ebene der Folie. Beispielsweise kann bei einer Draufsicht auf die Wärmeleitfolie ein Entwärmungsbereich (oder ein Fixierungsbereich) eine quadratische, rechteckige, dreieckige, mehreckige, abgerundete, ellipsenförmige, kreisförmige, und/oder streifenförmige geometrische Erstreckung haben.

Entwärmungsbereiche und Fixierungsbereiche können unmittelbar aneinander angrenzen, es können jedoch auch Lücken zwischen benachbarten/beabstandeten Bereichen in der Wärmeleitfolie vorliegen. Es können auch Entwärmungsbereiche unmittelbar oder auf Lücke aneinander angrenzen, wenn beispielsweise ein Entwärmungsmaterial segmentiert vorliegt, oder unterschiedliche Entwärmungsmaterialien in nebeneinander liegenden Schichten, Streifen, etc. verarbeitet werden.

Erfindungsgemäß weist der Entwärmungsbereich eine bessere Wärmeleitungseigenschaft auf als der Fixierungsbereich und der Fixierungsbereich weist eine bessere Fixierungseigenschaft auf als der Entwärmungsbereich. Eine Wärmeleitungseigenschaft kann beispielsweise die Eigenschaft eines Materials betreffen, Wärme aufzunehmen, abzugeben oder weiterzuleiten. Eine Fixierungseigenschaft kann die Eigenschaft eines Materials betreffen, an mindestens einem anderen Material zu haften, etwa mittels einer Klebewirkung.

Eine geometrische Form und/oder Anordnung von Entwärmungsbereichen und/oder Fixierungsbereichen kann an das mindestens eine zu entwärmende Bauelement angepasst sein.

Es können bei der erfindungsgemäßen Wärmeleitfolie eine Mehrzahl diskreter Entwärmungsbereiche vorgesehen sein. Betreffen etwa die Entwärmungsanforderungen eine Mehrzahl an "Hot Spots", z.B. eine Mehrzahl zu entwärmender Bauelemente und/oder eine Mehrzahl Entwärmungsflächen eines einzelnene Bauelementes, kann jeweils mindestens ein Entwärmungsbereich für einen Hot Spot vorgesehen sein.

Eine Mehrzahl von Entwärmungsbereichen kann in einen gemeinsamen Fixierungsbereich eingebettet sein. Der gemeinsame Fixierungsbereich kann beispielsweise als Kleberahmen ausgestaltet sein, der gegebenenfalls mittels Stegen Entwärmungsbereiche voneinander separiert. Der Kleberahmen kann ein oder mehrere Entwärmungsbereiche ganz oder teilweise umfassen bzw. umgeben.

Der Entwärmungsbereich umfasst eine Entwärmungsschicht, die mindestens ein Entwärmungsmaterial umfasst. Zusätzlich umfasst der Fixierungsbereich eine Fixierungsschicht, die mindestens ein Fixierungsmaterial aufweist. Entwärmungsschicht und Fixierungsschicht liegen in derselben Ebene der Folie, d.h. "nebeneinander" in der Folienebene.

Das mindestens eine Entwärmungsmaterial und das mindestens eine Fixierungsmaterial unterscheiden sich in mindestens einem Material. Die Fixierungsschicht kann als Fixierungsmaterial beispielsweise einen Klebstoff wie einen Acrylat- oder Epoxyklebstoff umfassen. Das Entwärmungsmaterial kann beispielsweise ein Phase-Change-Material (PCM) und/oder ein thermisch leitfähiges Pad umfassen. Die Entwärmungsschicht umfasst erfindungsgemäß zwei oder mehrere Unterschichten, beispielsweise eine PCM-Schicht und eine Gelschicht oder Gap-Filler-Schicht. Die Entwärmungsschicht ist dicker als die Fixierungsschicht, wobei die Entwärmungsschicht für eine Kompression durch das zu entwärmende Bauelement und/oder einen Kühlkörper bzw. ein Gehäuseteil vorgesehen sein kann.

Bei Varianten der vorgenannten Ausführungsformen ist die Entwärmungsschicht frei von Fixierungsmaterial. Die Wärmeleitfolie umfasst erfindungsgemäß eine Trägerfolie, auf deren Oberfläche zur Ausbildung der Entwärmungs- bzw. Fixierungsbereiche ein- oder beidseitig Entwärmungs- und Fixierungsmaterial aufgebracht ist. Bei der Trägerfolie kann es sich beispielsweise um eine Metall- oder Polyimidfolie handeln.

### Vorteile der Erfindung

Die erfindungsgemäßen klebenden Wärmeleitfolien mit Strukturierung umfassen eine Kombination aus Bereichen, die auf mechanische Fixierung (Klebung) optimiert sind (Fixierungsbereiche), und aus Bereichen, die auf thermische Performance optimiert sind (Entwärmungsbereiche). Beim Design einer derartigen Folie können unter Berücksichtigung der zu entwärmenden Hotspots solche Bereiche der Folie, die nur einen geringen Beitrag zur Entwärmung liefern, für die Fixierung genutzt werden. Umgekehrt kann dann in den Entwärmungsbereichen auf die Fixierungs-/Klebefunktion gegebenenfalls ganz oder teilweise verzichtet werden.

Gegenüber den bekannten klebenden Wärmeleitfolien mit ihrer homogenen Zusammensetzung weisen die erfindungsgemäß strukturierten Wärmeleitfolien zahlreiche Vorteile auf. Durch das Vorsehen von nebeneinanderliegenden diskreten bzw. separaten Entwärmungs- und Fixierungsbereichen kann eine Wärmeleitungsfunktionalität auf die Hotspots von Schaltungen optimiert werden: An den Hotspots können Entwärmungsbereiche vorgesehen werden, die beispielsweise durch Materialien besonders hoher Wärmeleitfähigkeit realisiert werden, während andere Bereiche der Folie als Fixierungsbereiche mit einem Fixierungsmaterial wie einem Klebstoff ausgebildet werden. Das verwendete Fixierungsmaterial (Klebstoff) kann auf seine Fixierungs- bzw. Haftungseigenschaften optimiert werden, wobei die thermische Performance zurücktreten kann, weil der Klebstoff nur oder überwiegend in Fixierungsbereichen, aber nicht oder nur in geringerem Maße in Entwärmungsbereichen zum Einsatz kommt. In gleicher Weise kann das in dem oder den Entwärmungsbereichen verwendete Wärmeleitmaterial bzw. -medium (bzw. die verwendeten Wärmeleitmedien) auf thermische Performance des Entwärmungsbereichs/des Gesamtsystems hin optimiert werden, ohne dass Fixierungseigenschaften berücksichtigt werden müssen.

Somit kann das Entwärmungsmaterial unabhängig von dem gewählten Fixierungsmaterial auf das Entwärmungspotenzial optimiert werden, während umgekehrt das Fixierungsmaterial unabhängig von der Wahl des Entwärmungsmaterials auf fixierende Eigenschaften optimiert werden kann.

In Entwärmungsbereichen kann beispielsweise ganz auf Klebstoff oder dergleichen verzichtet werden, wenn die Fixierungseigenschaft vollständig von den hierfür vorgesehenen Fixierungsbereichen der Wärmeleitfolie übernommen wird. Oftmals werden durch das Vorsehen geeigneter Fixierungsbereiche und entsprechend optimierter Fixierungsmittel weniger oder gar keine weiteren mechanischen Fixierungen erforderlich sein, d.h. es kann u.U. auf das Vorsehen von Schrauben, Klemmen oder dergleichen ganz oder teilweise verzichtet werden. Dennoch kann eine sehr gute Entwärmung bei gleichzeitiger guter mechanischer Fixierung erreicht werden. Die Erfindung erlaubt die einfache Applikation einer klebenden Wärmeleitfolie, z.B. in Form von "pick & place".

### Kurze Beschreibung der Zeichnungen

Weitere Aspekte und Vorteile der Erfindung werden nunmehr anhand der beigefügten Figuren eingehender beschrieben. Hierbei zeigt:
- Figur 1: Ein erstes Ausführungsbeispiel einer erfindungsgemäßen klebenden Wärmeleitfolie in einer Draufsicht;
- Figur 2: Ein zweites Ausführungsbeispiel einer erfindungsgemäßen, klebenden Wärmeleitfolie in der Draufsicht;
- Figur 3: Ein drittes Ausführungsbeispiel einer erfindungsgemäßen, klebenden Wärmeleitfolie im Querschnitt; und
- Figur 4: Ein viertes Ausführungsbeispiel einer erfindungsgemäßen, klebenden Wärmeleitfolie im Querschnitt.

### Ausführungsformen der Erfindung

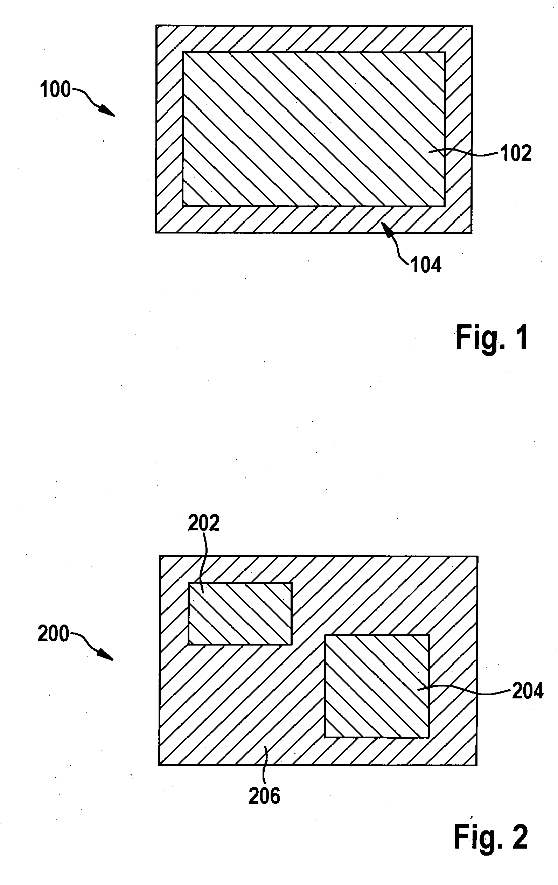

In Fig. 1 ist in Form einer schematischen Draufsicht ein erstes Ausführungsbeispiel 100 einer erfindungsgemäßen Wärmeleitfolie gezeigt. Die Wärmeleitfolie 100 umfasst einen Entwärmungsbereich 102, der in einen einzelnen Fixierungsbereich 104 eingebettet ist. Wie durch die unterschiedliche Schraffur angedeutet, unterscheidet sich das zur Realisierung des Entwärmungsbereiches 102 verwendete Entwärmungsmaterial vom Fixierungsmaterial im Fixierungsbereich 104. Beispielsweise kann der Entwärmungsbereich 102 durch eine PCM-Schicht mit einem PCM-Material und der Fixierungsbereich 104 durch eine Klebeschicht mit einem Klebematerial gebildet sein.

Der Fixierungsbereich 104 umfasst bzw. umgibt den Entwärmungsbereich 102 in Form eines Kleberahmens. Die Wärmeleitfolie 100 kann mit Hilfe des Kleberahmens auf einem zu entwärmenden Bauelement (und/oder einem Gehäuse, einem Kühlkörper oder dergleichen) fixiert werden, so dass der Entwärmungsbereich 102 in mechanischen und thermischen Kontakt mit der zu entwärmenden Anordnung gelangt, die bspw. ein Bauelement oder mehrere Bauelemente einer Schaltung umfassen kann.

Die Entwärmungsschicht im Entwärmungsbereich 102 kann mindestens ein Entwärmungsmaterial umfassen, das einen guten thermischen Kontakt ermöglicht, beispielsweise ein PCM und/oder ein Pad. Zusätzlich oder alternativ kann das Entwärmungsmaterial solche Materialien umfassen, die eine Wärmeaufnahme von der zu entwärmenden Anordnung, eine Wärmeweiterleitung innerhalb der Wärmeleitfolie 100 (senkrecht zur und/oder innerhalb der Zeichenebene) und/oder zur weiteren thermischen Diffusion in Richtung auf Wärmesenken wie Kühlkörper, Gehäuseteile, Luft, etc. aufweisen, Beispielsweise kann das Entwärmungsmaterial eine Metallfolie umfassen.

Soweit es zur Optimierung des thermischen Kontaktes beiträgt, kann auch der Entwärmungsbereich 102 mit einem Fixierungsmaterial versehen sein, wobei hierbei z.B. ein anderes Fixierungsmaterial als im Fixierungsbereich 104 (z.B. ein stärker auf thermische Performance und weniger auf klebende Wirkung hin optimierter Klebstoff) oder weniger Fixierungsmaterial als im Bereich 104 vorgesehen sein kann. Der Fixierungsbereich 104 ist demgegenüber auf die Fixierung der Wärmeleitfolie 100 optimiert, beispielsweise durch die Wahl eines geeigneten Klebstoffs, der zwar keine optimale thermische Performance, dafür aber eine optimale Fixierungswirkung (Haftungswirkung) in Bezug auf die Verbindung mit dem zu entwärmenden Bauelement und/oder der Diffusionskomponente, d.h. dem Gehäuse, Kühlkörper oder dergleichen hat.

Fig. 2 zeigt in einer schematischen Draufsicht ein weiteres Ausführungsbeispiel 200 einer erfindungsgemäßen Wärmeleitfolie, bei der zwei Entwärmungsbereiche 202, 204 in einen gemeinsamen Fixierungsbereich 206 eingebettet sind. Die Eigenschaften, Materialien etc. der Wärmeleitfolie 200 können sinngemäß denen der Folie 100 aus der Fig. 1 entsprechen.

Die Anordung, Form und Größe der beiden Entwärmungsbereiche 202 und 204 kann an einen oder mehrere Hot Spots einer Schaltung oder dgl. angepasst sein. Dabei kann einer der Entwärmungsbereiche 202, 204 einen Hot Spot oder eine Mehrzahl Hot Spots (z.B. ein Bauelement oder eine Mehrzahl an Bauelementen) jeweils überdecken. Der Fixierungsbereich 206 bildet einen Kleberahmen um jeden der Bereiche 202, 204 sowie einen gemeinsamen Rahmen, der beide Entwärmungsbereiche 202, 204 zusammen umfasst. Auf diese Weise kann eine zuverlässige Fixierung von Folie 200 und zu entwärmender Anordung erreicht werden.

Weitere Ausführungsbeispiele (nicht gezeigt) umfassen nicht nur einen Entwärmungsbereich (wie in Fig. 1) oder zwei Entwärmungsbereiche (wie in Fig. 2), sondern eine Vielzahl von Entwärmungsbereichen, die bspw. in einen oder mehrere Fixierungsbereiche eingebettet sein können, wie dies prinzipiell in den Figuren 1 und 2 gezeigt ist. Weiterhin können der ein oder die mehreren Fixierungsbereich/e einen Kleberahmen für ein oder mehrere Entwärmungsbereiche oder einen gemeinsamen Rahmen für ein oder mehrere Entwärmungsbereiche bilden, der die ein oder mehreren Entwärmungsbereiche vollständig oder zumindest teilweise umfasst. Eine Ausführungsform, bei der die ein oder mehreren Fixierungsbereiche den einen oder die mehreren Entwärmungsbereiche nur teilweise umfassen, hat den Vorteil, dass das Entwärmungsmaterial aus dem von einem Fixierungsbereich gebildeten Rahmen herausgedrückt werden kann. Das Entwärmungsmaterial kann also aus dem Entwärmungsbereich austreten. Der Austritt erfolgt dabei in den Bereichen des Rahmens, wo der Entwärmungsbereich offen ist, d.h. von keinem Fixierungsbereich umfasst ist.

Ausführungsbeispiele erfindungsgemäßer Wärmeleitfolien können neben Entwärmungsbereichen und Fixierungsbereichen auch weitere Bereiche umfassen, die nicht in spezieller Weise auf Entwärmung oder Fixierung optimiert sind. Beispielsweise kann es sich bei derartigen Bereichen um Bereiche handeln, die für eine mechanische Kontaktierung / Fixierung der Folie mittels Klammern, Schrauben oder dergleichen Befestigungsmitteln vorgesehen ist, und/oder um Bereiche, die für eine elektrische (Durch-)Kontaktierung der Folie vorgesehen sind. Beispielsweise kann eine erfindungsgemäße Wärmeleitfolien eine Trägerfolie aufweisen, und ein Bereich, in dem die Trägerfolie freiliegt, kann zur Befestigung und/oder Kontaktierung vorgesehen sein.

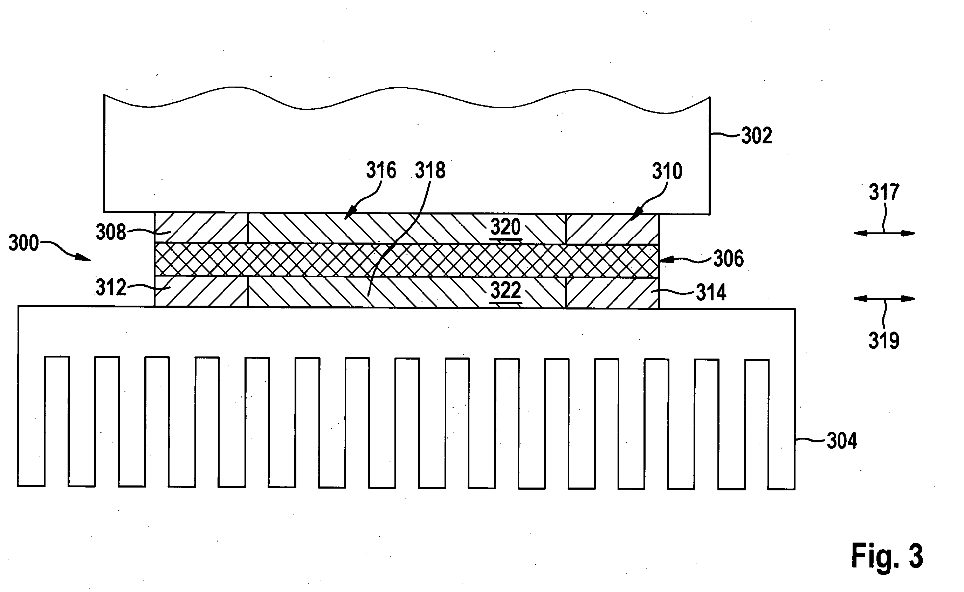

In Fig. 3 ist in schematischer Querschnittsansicht ein weiteres Ausführungsbeispiel 300 einer erfindungsgemäßen Wärmeleitfolie zur thermischen Kontaktierung einer Bauelementanordnung 302 mit einem Kühlkörper 304 in einer schematischen Schnittansicht gezeigt. Bei der Anordnung 302 kann es sich beispielsweise um eine mit Bauelementen bestückte Leiterplatte, ein LTCC, oder sonst einen Schaltungsträger handeln.

Die Folie 300 umfasst eine Trägerfolie 306, die beidseitig in Fixierungsbereichen 308, 310, 312, 314 mit Fixierungsmaterial belegt ist und in Entwärmungsbereichen 316 und 318 mit Entwärmungsmaterial belegt ist. Der Entwärmungsbereich 316 sowie die Fixierungsbereiche 308 und 310 erstrecken sich flächig in einer durch den Doppelpfeil 317 angedeuteten Folienebene. Der Entwärmungsbereich 318 sowie die Fixierungsbereiche 312 und 314 erstrecken sich flächig in einer durch den Doppelpfeil 319 angedeuteten Folienebene.

Die Trägerfolie 306 kann der Stabilität der Wärmeleitfolie 300 dienen, ein einfacheres Handling der Folie 300 ermöglichen, zur elektrischen Isolation, und/oder zur Erzielung weiterer Eigenschaften dienen. Die Trägerfolie 300 kann etwa eine Metallfolie umfassen und/oder eine Polyimidfolie.

Bei dem in den Bereichen 308-314 verwendeten Fixierungsmaterial kann es sich etwa um einen Klebstoff wie ein Acryl- oder ein Epoxydharz handeln. Die in den Fixierungsbereichen 308-314 verwendeten Fixierungsmittel können unterschiedliche sein. Zum Beispiel kann das in den Fixierungsbereichen 308 und 310 vorliegende Fixierungsmaterial einen Klebstoff umfassen, der optimal für die Fixierung der Folie 300 an der Bauelementeanordnung 302 ist, während das in den Fixierungsbereichen 312 und 314 vorliegende Fixierungsmaterial einen anderen Klebstoff umfasst, der optimal für die Fixierung der Folie 300 am Kühlkörper 304 ist.

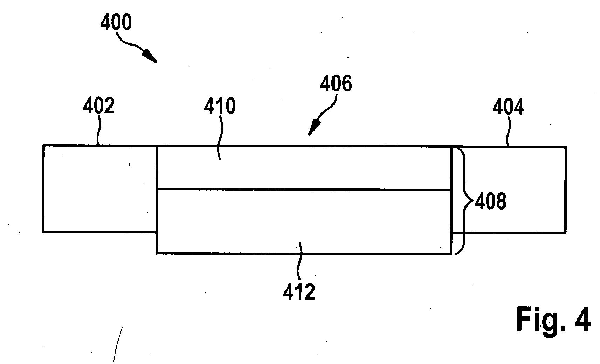

Die in den Entwärmungsschichten der Entwärmungsbereiche 316 und 318 verwenden Entwärmungsmaterialien können separat auf thermische Performance optimiert werden. So ist in dem Beispiel der Fig. 3 zur optimalen thermischen Kontaktierung der Bauelementanordnung 302 im Entwärmungsbereich 316 eine Entwärmungsschicht 320 vorgesehen, die vor einer Kontaktierung dicker ist als die Fixierungsschicht in den Fixierungsbereichen 308 und 310 (in Fig. 3 nicht zu sehen, vgl. hierzu Fig. 4). Bei dem Entwärmungsmaterial der Entwärmungsschicht 320 kann es sich z.B. um ein Gap-Filler-Material handeln, welches bei Aufkleben der Folie 300 auf die Anordnung 302 durch Bauelemente der Anordnung 302 komprimiert wird; auf diese Weise wird ein enger mechanischer und thermischer Kontakt mit der Anordnung 302 erreicht.

Im Gegensatz hierzu kann das Entwärmungsmaterial der Entwärmungsschicht 322 im Entwärmungsbereich 318 für eine optimale thermische Kontaktierung mit dem Kühlkörper 304 ein PCM umfassen, welches sich bei Temperaturen verflüssigt (bspw. zumindest zähflüssig wird), wie sie beim Betrieb der Anordnung 302 auftreten, und somit einen engen mechanischen Kontakt und eine optimierte Wärmeleitung von der Trägerfolie 300 zum Kühlkörper 304 ermöglicht. Die Entwärmungsbereiche 316 und 318 können frei von jeglichem Fixierungsmaterial sein.

In Fig. 4 ist in schematischer Querschnittsansicht ein weiteres Ausführungsbeispiel 400 einer erfindungsgemäßen Wärmeleitfolie angedeutet. Diese verfügt über Fixierungsbereiche 402 und 404 sowie einen Entwärmungsbereich 406. Der Entwärmungsbereich 406 umfasst eine Entwärmungsschicht 408 mit zwei Unterschichten 410, 412. In der Unterschicht 412 wird als Entwärmungsmaterial ein Gap-Filler-Material verwendet, welches über die Fixierungsschichten in den Bereichen 402 und 404 erhaben ist. Das Material der Unterschicht 412 wird beim Ankleben der Folie 400 an eine Bauelementanordnung komprimiert. Das in der Unterschicht 410 verwendete Entwärmungsmaterial kann ein PCM-Material umfassen, welches im Betrieb einen guten Kontakt zu einer thermischen Diffusionskomponente wie einem Kühlkörper oder einem Gehäuseteil gewährleistet.

Weitere Ausführungsbeispiele erfindungsgemäßer Wärmeleitfolien können statt zwei Unterschichten wie in Fig. 4 auch Entwärmungsbereiche mit einer größeren Anzahl an Unterschichten umfassen.

Die Erfindung ist nicht auf die hier beschriebenen Ausführungsbeispiele und die darin hervorgehobenen Aspekte beschränkt; vielmehr sind innerhalb des durch die anhängenden Ansprüche angegebenen Bereichs eine Vielzahl von Abwandlungen möglich, die im Rahmen fachmännischen Handelns liegen.

## Patentansprüche

1. Wärmeleitfolie (100, 200, 300, 400) zur Entwärmung und Fixierung mindestens eines elektrischen und/oder elektronischen Bauelements (302), mit mindestens einem diskreten Entwärmungsbereich (102, 202, 204, 316, 318, 406) und mindestens einem diskreten Fixierungsbereich (104, 206, 308 - 314, 402, 404), wobei sich die Bereiche (308 - 316, 318) jeweils flächig in einer Ebene (317, 319) der Folie (300) erstrecken, und
- der Entwärmungsbereich (102, 202, 204, 316, 318, 406) eine bessere Wärmeleitungseigenschaft hat als der Fixierungsbereich (104, 206, 308 - 314, 402, 404), und
- der Fixierungsbereich (104, 206, 308 - 314, 402, 404) eine bessere Fixierungseigenschaft hat als der Entwärmungsbereich (102, 202, 204, 316, 318, 406), wobei der Entwärmungsbereich (316; 318) eine Entwärmungsschicht (320; 322) umfassend mindestens ein Entwärmungsmaterial und der Fixierungsbereich (308, 310; 312, 314) eine Fixierungsschicht umfassend mindestens ein Fixierungsmaterial aufweist, und die Entwärmungsschicht (320; 322) und Fixierungsschicht (308, 310; 312, 314) in derselben Ebene (317; 319) der Folie (300) liegen und das Entwärmungsmaterial sich von dem Fixierungsmaterial unterscheidet, wobei die Entwärmungsschicht (408) dicker ist als die Fixierungsschicht, **dadurch gekennzeichnet, dass** die Entwärmungsschicht (408) zwei oder mehr Unterschichten (410, 412) umfasst, und die Wärmeleitfolie (300) eine Trägerfolie (306) umfasst, die ein- oder beidseitig mit Entwärmungs- und Fixierungsmaterial zur Ausbildung der Entwärmungs- und Fixierungsbereiche belegt ist.

2. Wärmeleitfolie nach Anspruch 1, wobei eine geometrische Form und/oder gegenseitige Anordnung des mindestens einen Entwärmungsbereichs (202, 204) und/oder des mindestens einen Fixierungsbereichs an das mindestens eine zu entwärmende Bauelement angepasst ist.

3. Wärmeleitfolie nach Anspruch 1 oder 2, wobei eine Mehrzahl (202, 204) diskreter Entwärmungsbereiche vorgesehen ist.

4. Wärmeleitfolie nach Anspruch 3, wobei eine Mehrzahl von Entwärmungsbereichen (202, 204) in einen gemeinsamen Fixierungsbereich (206) eingebettet sind.

5. Wärmeleitfolie nach Anspruch 1, wobei das Entwärmungsmaterial ein Phase-Change Material und/oder ein Pad umfasst.

6. Wärmeleitfolie nach einem der Ansprüche 1 bis 5, wobei die Entwärmungsschicht frei von Fixierungsmaterial ist.

## Claims

1. Thermally conductive film (100, 200, 300, 400) for cooling and fastening at least one electrical and/or electronic component (302), comprising at least one discrete cooling region (102, 202, 204, 316, 318, 406) and at least one discrete fastening region (104, 206, 308-314, 402, 404), said regions (308-316, 318) respectively extending in a planar manner in a plane (317, 319) of the film (300), and
- the cooling region (102, 202, 204, 316, 318, 406) having a better thermal conduction property than the fastening region (104, 206, 308-314, 402, 404), and
- the fastening region (104, 206, 308-314, 402, 404) having a better fastening property than the cooling region (102, 202, 204, 316, 318, 406), the cooling region (316; 318) having a cooling layer (320; 322) comprising at least one cooling material and the fastening region (308, 310; 312, 314) having a fastening layer comprising at least one fastening material, and the cooling layer (320; 322) and the fastening layer (308, 310; 312, 314) lying in the same plane (317; 319) of the film (300) and the cooling material differing from the fastening material, the cooling layer (408) being thicker than the fastening layer, **characterized in that** the cooling layer (408) comprises two or more sublayers (410, 412), and the thermally conductive film (300) comprises a carrier film (306), which is covered on one or both sides with cooling and fastening material to form the cooling and fastening regions.

2. Thermally conductive film according to Claim 1, a geometrical form and/or mutual arrangement of the at least one cooling region (202, 204) and/or of the at least one fastening region being adapted to the at least one component to be cooled.

3. Thermally conductive film according to Claim 1 or 2, a plurality (202, 204) of discrete cooling regions being provided.

4. Thermally conductive film according to Claim 3, a plurality of cooling regions (202, 204) being embedded in a common fastening region (206).

5. Thermally conductive film according to Claim 1, the cooling material comprising a phase-change material and/or a pad.

6. Thermally conductive film according to one of Claims 1 to 5, the cooling layer being free from fastening material.

## Revendications

1. Feuille thermoconductrice (100, 200, 300, 400) pour dissiper la chaleur et fixer au moins un composant électrique et/ou électronique (302), comprenant au moins une zone de dissipation de la chaleur distincte (102, 202, 204, 316, 318, 406) et au moins une zone de fixation distincte (104, 206, 308-314, 402, 404), les zones (308-316, 318) s'étendant à chaque fois à plat dans un plan (317, 319) de la feuille (300), et
- la zone de dissipation de la chaleur (102, 202, 204, 316, 318, 406) présentant une meilleure propriété de conduction thermique que la zone de fixation (104, 206, 308-314, 402, 404), et
- la zone de fixation (104, 206, 308-314, 402, 404) présentant une meillure propriété de fixation que la zone de dissipation de la chaleur (102, 202, 204, 316, 318, 406) la zone de dissipation de la chaleur (316 ; 318), comprenant une couche de dissipation de la chaleur (320 ; 322), présentant au moins un matériau de dissipation de la chaleur et la zone de fixation (308, 310 ; 312, 314), comprenant une couche de fixation, présentant au moins un matériau de fixation et la couche de dissipation de la chaleur (320 ; 322) et la couche de fixation (308, 310 ; 312, 314) étant situées dans le même plan (317 ; 319) de la feuille (300) et le matériau de dissipation de la chaleur étant distinct du matériau de fixation, la couche de dissipation de la chaleur (408) étant plus épaisse que la couche de fixation, **caractérisée en ce que** la couche de dissipation de la chaleur (408) comprend deux ou plus de deux couches inférieures (410, 412) et la feuille thermoconductrice (300) comprenant une feuille de support (306) qui est revêtue d'un côté ou des deux côtés avec le matériau de dissipation de la chaleur et de fixation pour créer les zones de dissipation de la chaleur et de fixation.

2. Feuille thermoconductrice selon la revendication 1, dans laquelle une forme géométrique et/ou un agencement mutuel de l'au moins une zone de dissipation de la chaleur (202, 204) et/ou de l'au moins une zone de fixation sont adaptés à l'au moins un composant dont la chaleur doit être dissipée.

3. Feuille thermoconductrice selon la revendication 1 ou 2, dans laquelle une pluralité (202, 204) de zones de dissipation de la chaleur distinctes est prévue.

4. Feuille thermoconductrice selon la revendication 3, dans laquelle une pluralité de zones de dissipation de la chaleur (202, 204) est incorporée dans une zone de fixation commune (206).

5. Feuille thermoconductrice selon la revendication 1, dans laquelle le matériau de dissipation de la chaleur comprend un matériau à changement de phase et/ou une plage.

6. Feuille thermoconductrice selon l'une quelconque des revendications 1 à 5, dans laquelle la couche de dissipation de la chaleur est exempte de matériau de fixation.
